# EUROPEAN PATENT APPLICATION

(11) **EP 1 788 126 A1**
(43) Date of publication of application: **23.05.2007**
(21) Application number: 06124395.2
(22) Date of filing: 20.11.2006
(51) Int. Cl.: C30B 29/40, C30B 25/02, H01L 33/00

(54) **Method of manufacturing single crystalline gallium nitride thick film**

(30) Priority: 22.11.2005 KR 20050111583 P
(71) Applicant: Samsung Corning Co., Ltd., Kyungki-do 443-732 (KR)
(72) Inventor: Shin, Hyun Min Samsung Corning Co., Seoul 131-206 (KR); Lee, Chang Ho Samsung Corning Co., Seocho-gu, Seoul 137-797 (KR)
(74) Representative: Rupprecht, Kay

(57) **Abstract**

A method of manufacturing a single crystalline gallium nitride (GaN) thick film grown by loading a base substrate in a hydride vapor phase epitaxy (HVPE) reactor, the method including: growing a first GaN film at a first temperature, in the surface kinetics-controlled regime, where a growth rate is determined by the reaction rate on a film surface; and growing a second GaN film on the first GaN film at a second temperature, in the mass transport-controlled regime, where the growth rate is determined by a material transport in the vapor phase, wherein a growth temperature of the second GaN film is higher than that of the first GaN film. According to the present invention, defects, bending, and cracks may be reduced and the crystalline GaN thick film of excellent crystal quality may be manufactured.

## Description

### CROSS-REFERENCE TO RELATED APPLICATION

This application claims the benefit of Korean Patent Application No. 10-2005-0111583, filed on November 22, 2005, in the Korean Intellectual Property Office, the disclosure of which is incorporated herein by reference.

### 1. Field of the Invention

The present invention relates to a method of manufacturing a single crystalline gallium nitride thick film of which defects and cracks are reduced and crystalline quality is improved by using a hydride vapor phase epitaxy (HVPE).

### 2. Description of Related Art

A single crystalline gallium nitride (GaN) thick film can be grown on a single crystalline substrate of the same kind, i.e. a GaN substrate, but the single crystalline GaN thick film has been mainly grown on a single crystalline substrate of different kind, for example, a sapphire substrate, i.e. heteroepitaxial growth. Here, internal stress occurs in the GaN layer near the interface due to lattice mismatch between the GaN layer and the different kind of single crystalline substrate (for example, thermal expansion coefficient between a sapphire substrate and GaN is more than 36%, and lattice mismatch is more than 16%) and more stress is accumulated at the interface during cooling after growing, cracks occur when growing more than certain thickness, and dislocations are generated from the interface of the sapphire and the GaN in order to relieve strain. These dislocations are propagated in the direction of crystal growth, threading dislocations are propagated all the way to the growth surface, and then impair the crystalline quality of a GaN semiconductor thick film, and ultimately deteriorate electrical performance of a device.

To solve the above described and/or other problems, a method of growing the single crystalline GaN thick film after growing a strain buffer layer on the single crystalline substrate has been primarily used, but demerits outweigh merits in that this buffer layer method of a heterogeneous buffer results in a mismatching of crystalline lattice when growing the single crystalline GaN film.

Accordingly, in order to reduce the number of crystalline defects and dislocations, extensive research on the epitaxial lateral overgrowth (ELOG), which is disclosed in U.S. Patent No. 6,051,849, the PENDEO epitaxy, which is disclosed in U.S. Patent No. 6,265,289, facet-initiated epitaxial lateral overgrowth (FIELO), which is referred to literature Jpn. J. Appl. Phys. 36, L899 (1997), etc. have been underway. According to the aforementioned methods, after the GaN thin film, is first grown on a single crystalline substrate, i.e., sapphire or GaAs, the GaN thin film is patterned by using the mask, and then the patterned GaN is exposed and etched to be subsequently grown. With the above-described method GaN thin films with few defects can be laterally grown over the mask area, however it is difficult to obtain a surface of uniformly distributed dislocations over the whole substrate because most dislocations exist in the area between the masks. This method, however, causes bending and cracking problems during cooling after growth of the GaN layer because of the incomplete coalescence of GaN films grown over each mask.

Accordingly, in the present invention, the growth rate and the surface morphology of a single crystalline GaN thick film grown on a substrate were found to be controlled by the growth temperature during growth, so that, the single crystalline GaN thick films with reduced dislocation density and cracks were manufactured by controlling the growth mode in connection with the growth temperature during growth.

### BRIEF SUMMARY

The present invention provides a method of manufacturing a single crystalline gallium nitride (GaN) thick film of excellent crystal quality by reducing the number of defects and cracks.

According to an aspect of the present invention, there is provided a method of manufacturing a single crystalline GaN thick film grown by loading a single crystalline substrate in a hydride vapor phase epitaxy (HVPE) reactor and providing metal gallium (Ga), hydrogen chloride (HCl) and ammonia (NH₃) gas, the method including: growing a first GaN film at a first temperature in the surface kinetics-controlled regime, where a growth rate is determined by the reaction rate on the film surface; and growing a second GaN film on the first GaN film at a second temperature, in the mass transport-controlled regime, where the growth rate is determined by the material transport in the vapor phase, wherein a growth temperature of the second GaN film is higher than that of the first GaN film.

### BRIEF DESCRIPTION OF THE DRAWINGS

The above and/or other aspects and advantages of the present invention will become apparent and more readily appreciated from the following detailed description, taken in conjunction with the accompanying drawings of which:
FIG. 1 is a graph illustrating change of a growth rate depending on the growth temperature of a single crystalline gallium nitride (GaN) on a sapphire substrate where black circles • designate the case for the hydrogen chloride (HCl) flow rate of 300 sccm, while white circles ○ designate the case for the HCl flow rate of 400 sccm;
FIGS. 2a, 2b and 2c are scanning electron microscopy (SEM) micrographs of the GaN film surface at different temperatures, designated as the point A, B and C in FIG. 1; and
FIG. 3 is a typical temperature profile during growth of the single crystalline GaN thick film according to an embodiment of the present invention.

### DETAILED DESCRIPTION OF EMBODIMENTS

Reference will now be made in detail to exemplary embodiments of the present invention, examples of which are illustrated in the accompanying drawings, wherein like reference numerals refer to the like elements throughout. The exemplary embodiments are described below in order to explain the present invention by referring to the figures.

According to the present invention, with the aid of the hydride vapor phase epitaxy (HVPE) for manufacturing the single crystalline gallium nitride (GaN) thick film, the first GaN film layer is grown on a single crystalline substrate of different kind in surface kinetics-controlled regime, to mitigate stress between the base substrate and the GaN layer and the second GaN film layer with mirror-like surface morphology is subsequently deposited on the first GaN layer at a higher temperature in the mass transport regime.

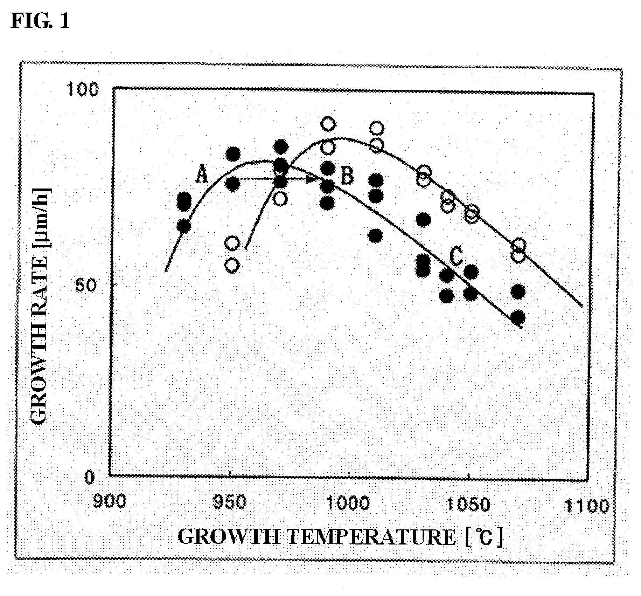

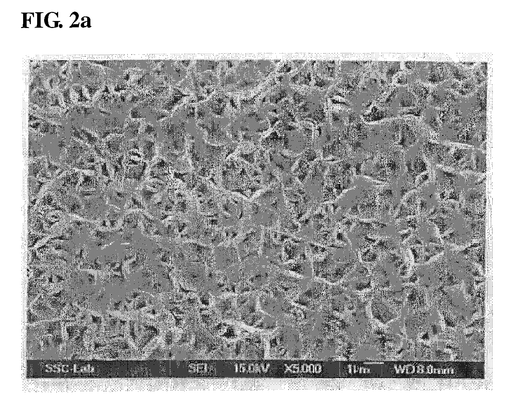

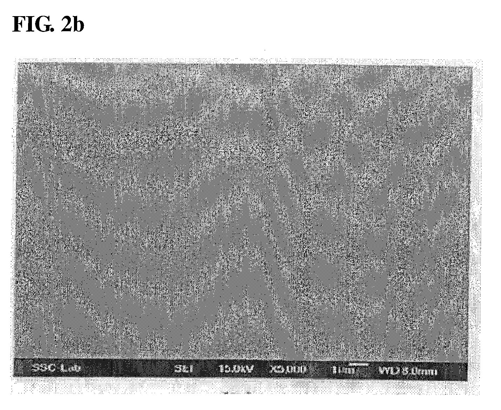

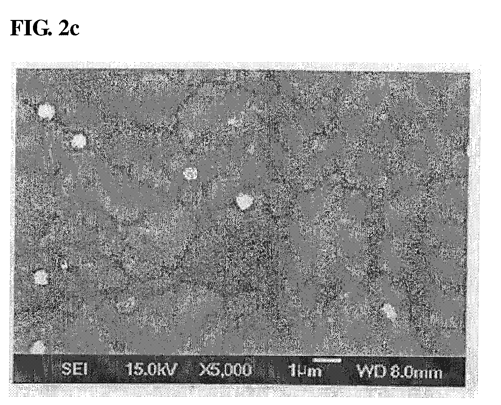

The present inventive technology is designed based on the fact that the growth rate and the surface morphology of the single crystalline GaN change with the growth temperature. FIG. 1 shows the change of the growth rate with the growth temperature and FIGS. 2a, 2b and 2c are scanning electron microscopy (SEM) micrographs of the GaN film surface at different temperatures, designated as the point A, B and C in FIG. 1. Referring to FIG. 1, a curve consisting of black circles (•) is the case when hydrogen chloride (HCl) supply as a source material corresponds to about 300 sccm, and the curve consisting of white circles (o) is the case when HCl supply corresponds to about 400 sccm.

Referring to FIG. 1, as the growth temperature increases, the growth rate gradually increases, passes through a point indicating the maximum growth rate, and then decreases.

For example, when HCl supply corresponds to about 300 sccm, the growth rate constantly increases in temperatures ranging from about 930°C to about 970°C, at which the maximum growth rate occurs. In this temperature region, surface morphology is determined by absorption, diffusion and desorption of incoming atoms on the growing surface of GaN. This temperature region is referred to as "surface kinetics-controlled regime". In this temperature region, the GaN film with rough surface morphology can be obtained as illustrated in FIG. 2a (point A, 950°C), because surface reactions on the growing surface are restricted by the low temperature even though the source material is oversupplied.

As the growth temperature increases, surface diffusivity of adatoms increases so that the rough surface becomes smoother. At about 970°C, showing the maximum growth rate, the deposition rate of incoming source material provided onto the growing surface becomes compatible with the decomposition rate due to thermodynamic instability of GaN.

Thermodynamic instability increases in the temperature ranging from about 970°C, showing the maximum growth rate, to about 1040°C, and then the decomposition rate becomes faster than the deposition rate of source material. As a result, growth rate is decreased. Material transport in the vapor phase towards the growing surface through the boundary layer is the rate-determining step in this temperature range. This temperature range is referred to as "mass transport-controlled regime". In this temperature range, thermal energy on growing surface is sufficient enough for the surface reaction of most atoms to occur and the decomposition occurs simultaneously due to the thermodynamic instability. Therefore, the single crystalline GaN film with smooth surface can be obtained, as shown in FIG. 2b (point B, 990°C). Variation of the amount of the source material in this temperature does not significantly change the growing surface morphology of the single crystalline GaN.

However, as the growth temperature increases, decomposed surface morphology due to thermodynamic instability begins to appear as shown in FIG. 2c corresponding to point C (1050°C).

The rough surface morphology of the first GaN film formed in surface kinetics regime plays an important role in relieving stress between the base substrate and the GaN layer. However, this rough morphology ultimately deteriorates quality of the final substrate, so that increases the growth temperature into mass transport regime, induces the lateral growth, and forms the second smooth GaN film by decreasing defects and controlling surface form.

Referring to FIG. 1, when HCl supply corresponds to about 400 sccm, the growth rate curve generally moves towards the higher temperature than when HCl supply corresponds to about 300 sccm, and the maximum growth rate increases. This means that the growth temperature changes depending on an amount of gallium metal used.

According to HVPE of the present invention, using Ga metal and HCl gas as a gallium source and NH₃ gas as a nitrogen source, surface kinetics regime is correctly chosen within the temperature ranging from about 900°C to about 1000°C and mass transport regime is correctly chosen within the temperature ranging from about 950°C to about 1070°C. In any case, the temperature chosen in mass transport regime, i.e. the second growth temperature, is greater than the temperature chosen in surface kinetics regime, i.e. the first growth temperature.

It is desirable that the first temperature and the second temperature have the same growth rate. To determine each temperature, the growth rate curve like FIG. 1 is drawn, the second growth temperature in mass transport regime is chosen, i.e. point B. The temperature describing the same growth rate, i.e. point A, is found in surface kinetics regime and it can be the first growth temperature.

It is desirable that the growth time or the growth thickness in the first growth temperature is less than the growth time or the growth thickness in the second growth temperature. The GaN film thickness ranges from about 10µm to about 200µm.

According to the present invention, with placing the GaN in an HVPE reactor, maintaining the temperature ranging from about 600°C to about 900°C, flowing HCl gas into the reactor, forming gallium chloride gas, providing NH₃ gas through another inlet, the intended GaN can be made by a reaction of the gallium chloride and the NH₃ gas. At this time a volume ratio of the HCl gas and the NH₃ gas can be controlled to be from about 1:1 to about 1:20, and the gallium is used in an excess of quantity.

The base substrates can be used for the present invention are sapphire, GaN, silicon carbide, silicon, zinc oxide, lithium aluminate, lithium gallite or gallium arsenide substrate.

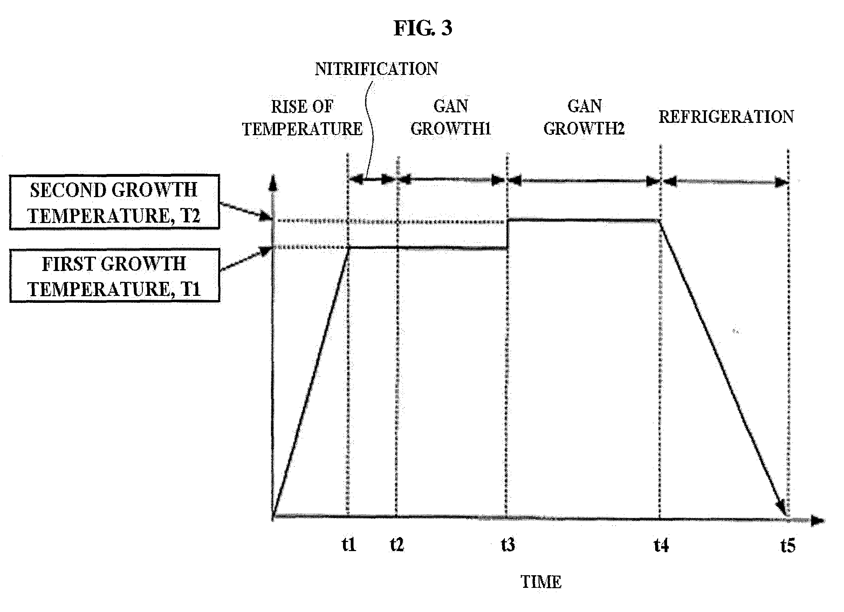

In order to grow a single crystalline GaN thick film of better quality, it is preferred to use the base substrate after nitridation. The nitridation method used in the present invention is the method disclosed in U.S. Patent No. 6,528,394 and specifically performed by providing NH₃ gas for the first nitridation, mixed gas of NH₃ and HCl, and NH₃ gas again for the second nitridation, to the base substrate at about 930°C to about 1000°C. According to another embodiment of the present invention, FIG. 3 illustrates the temperature profile depending on a growth time of the single crystalline GaN thick film. Referring to FIG. 3, the intended single crystalline GaN thick film is obtained by raising the temperature of the growing reactor to T1 until time t1, nitridation of the base substrate surface at this temperature until time t2, growing the first GaN film on the nitridated material until time t3, raising the growth temperature to T2 at time t3, growing the second GaN film until time t4, and cooling until time t5. Here, the total growth time can vary depending on a thickness of the GaN thick film.

According to the present invention, even though the single crystalline GaN thick film is thicker than 300 µm and longer than 50.8 mm, i.e. 2 inches in diameter is grown owing to the decrease of crack phenomenon as a result of stress relief effect and the decrease of defect density resulted from controlling growth mode, defects, bending, and cracks do not occur and the single crystalline GaN thick film can be grown indefinitely in thickness. A single crystalline GaN freestanding substrate of good quality is obtained by separating the grown single crystalline GaN thick film grown from the base substrate with laser, etc., and polishing one side or both side surfaces with an ordinary method.

The single crystalline GaN freestanding substrate manufactured by the present inventive method has the crystalline surface of {0001} side or {11-20} side, reduced defects, cracks, and excellent crystalline, and is useful for diverse electric and electrical semiconductor substrate.

Here in after, the present invention will be described in more detail through an example. Although a few exemplary embodiments of the present invention have been described, the present invention is not limited to the described exemplary embodiments. Instead, it would be appreciated by those skilled in the art that changes may be made to these exemplary embodiments without departing from the principles and spirit of the invention, the scope of which is defined by the claims and their equivalents.

### Example 1

After a sapphire single crystalline substrate having a diameter of 2 inches was loaded into a HVPE reactor, NH₃ gas at about 950°C was flowed, and the sapphire single crystalline substrate was first nitridated, thermally processed using mixed gas of NH₃ and HCl, and while the NH₃ gas was being flowed again, the second nitridation occurred. Subsequently, gallium was excessively loaded, located in a gallium container, maintaining a temperature at about 850°C, and HCl gas was flowed into the gallium container at a rate of about 300 sccm and gallium chloride (GaCl) gas was formed. NH₃ gas was flowed into another inlet and the first GaN film having a thickness of about 70 µm was grown on the nitridated sapphire single crystalline substrate at about 950°C by reacting with GaCl gas. Here, a volume ratio of the HCl gas and the NH₃ gas was controlled to be about 1:5. FIG 2a is a picture illustrating surface form of the first GaN film, which shows formation of the GaN film with the very rough surface.

The intended single crystalline GaN thick film was obtained by raising the reactor temperature to about 990°C immediately after completing the growth of the first GaN film and growing the second GaN film to a thickness of about 350 µm on the first GaN film. FIG. 2b is a picture illustrating the surface form of the formed second GaN film, which shows formation of the GaN film with the very smooth surface.

In this method, dislocation density of the single crystalline GaN thick film by photoluminescence mapping was about 3.5×10⁶/cm², a full width at half maximum (FWHM) value by X-Ray Diffraction (XRD) rocking curve was about 90 arcsec. It was identified that radius of curvature was about 0.6 m and was decreased more remarkably than average radius of curvature, i.e. about 0.25 m and stress was significantly released in the first GaN film because the fact that cracks did not occur in the surface and inside.

### Example 2

Except when the first GaN film was grown at about 930°C and the second GaN film was grown at about 1010°C, the intended single crystalline GaN thick film was manufactured with the same method as example 1.

In this method, dislocation density of the single crystalline GaN thick film by photoluminescence mapping was about 3×10⁶/cm², FWHM value byXRD rocking curve was about 82 arcsec. It was identified that radius of curvature was about 0.55 m and was decreased more remarkably than average radius of curvature, i.e. about 0.25 m and stress was significantly released in the first GaN film because the fact that cracks did not occur in the surface and inside.

### Example 3

Except when HCl gas was flowed at the rate of 400 sccm, the intended single crystalline GaN thick film was manufactured by performing HVPE with the same method as example 1.

In this method, dislocation density of the single crystalline GaN thick film by photoluminescence mapping was about 2.8×10⁶/cm², FWHM value by XRD rocking curve was about 72 arcsec. It was identified that radius of curvature was about 0.65 m and was decreased more remarkably than average radius of curvature, i.e. about 0.25 m and stress was significantly released in the first GaN film because the fact that cracks did not occur in the surface and inside.

### Example 4

Except when HCl gas was flowed at the rate of 400 sccm, the intended single crystalline GaN thick film was manufactured by performing HVPE with the same method as example 2.

In this method, dislocation density of the single crystalline GaN thick film by photoluminescence mapping was about 3×10⁶/cm² , FWHM value by XRD rocking curve was about 74 arcsec. It was identified that radius of curvature was about 0.58 m and was decreased more remarkably than average radius of curvature, i.e. about 0.25 m and stress was significantly relaxed in the first GaN film because the fact that cracks did not occur in the surface and inside.

According to the present invention, the single crystalline GaN thick films of excellent crystal quality with reduced dislocation density and cracks are manufactured. In this method, the single crystalline GaN thick film is useful for the substrate for an electric device or an electrical device.

Although a few exemplary embodiments of the present invention have been shown and described, the present invention is not limited to the described exemplary embodiments. While some of the preferred embodiments of the subject invention have been described and illustrated, various changes and modifications can be made therein without departing from the spirit of the present invention defined in the appended claims.

## Claims

1. A method of manufacturing a single crystalline gallium nitride (GaN) thick film grown by loading a base substrate in a hydride vapor phase epitaxy (HVPE) reactor, and providing gallium (Ga), hydrogen chloride (HCl) gas, and ammonia (NH3) gas, comprising the steps of :
a) growing a first GaN film at a first temperature (surface kinetics regime) where a growth rate is determined by a reaction speed on a film surface; and
b) growing a second GaN film on the first GaN film at a second temperature (mass transport regime) where the growth rate is determined by a material extension at a vapor phase,
wherein a growth temperature of step b) is greater than a growth temperature of step a) .

2. The method of claim 1, wherein the growth rate increases according to a rise of the temperature at the first temperature, and the growth rate decreases according to a rise of the temperature at the second temperature.

3. The method of claim 1, wherein the first temperature is in a range of about 900°C to about 1000°C.

4. The method of claim 1, wherein the second temperature is in a range of about 950°C to about 1070°C.

5. The method of claim 1, wherein the first temperature and the second temperature have the same growth rate.

6. The method of claim 1, wherein the growth time of the first GaN film is less than the growth time of the second GaN film.

7. The method of claim 6, wherein the first GaN film has a thickness of about 10 µm to about 200 µm.

8. The method of claim 1, wherein the nitridation of the base substrate is conducted in advance.

9. The method of claim 8, wherein the first nitridation of the base substrate is performed by providing NH3 gas at a temperature of about 930°C to about 1000°C, and then provide NH3 and HCl gas mixture, and the second nitridation is performed by providing NH3 gas.

10. The method of claim 1, wherein HCl and NH3 gas have the volume ratio from about 1:1 to about 1:20.

11. A single crystalline GaN thick film obtained through the method according to any one of claims 1 through 10.

12. A freestanding single crystalline GaN substrate obtained by separating and polishing the single crystalline GaN film of claim 11.

13. A semiconductor device comprising the freestanding single crystalline GaN substrate of claim 12.
